# EUROPEAN PATENT SPECIFICATION

(11) **EP 0 601 638 B1**
(45) Date of publication and mention of the grant of the patent: **26.07.2000**
(21) Application number: 93203358.2
(22) Date of filing: 01.12.1993
(51) Int. Cl.: H01L 27/148

(54) **Charge-coupled device**
Ladungsgekoppelte Anordnung
Dispositif à couplage de charge

(30) Priority: 09.12.1992 EP 92203825
(43) Date of publication of application: 15.06.1994
(73) Proprietor: Koninklijke Philips Electronics N.V., 5621 BA Eindhoven (NL)
(72) Inventor: Bosiers, Jan Theodoor Jozef, NL-5656 AA Eindhoven (NL); Roks, Edwin, NL-5656 AA Eindhoven (NL); Kleimann, Agnes Catharina Maria, NL-5656 AA Eindhoven (NL)
(74) Representative: Houbiers, Ernest Emile Marie Gerlach

(56) References cited:
- EP-A- 0 278 565
- EP-A- 0 399 551
- EP-A- 0 399 601
- EP-A- 0 506 188
- WO-A-91/03840
- US-A- 5 115 458

## Description

The invention relates to a buried-channel coupled imaging device of the frame-transfer type comprising a semiconductor substrate of a first conductivity type which is provided at a surface with a number of zones of the first conductivity type, which zones are separated from the substrate of the first conductivity type by an interposed zone of the second conductivity type opposite to the first, said zones forming a number of registers with buried channels situated next to one another, a first part of said registers forming an image section (A), an adjoining second part of said registers forming a memory section (B), located and connected between the image section and a parallel-in/serial-out read-out register, while the surface at the image section and the memory section is provided with a system of electrodes for applying clock voltages separated from the buried channels by an interposed dielectric layer and connected to a voltage source by means of which said clock-voltages are applied, an inversion layer of the second conductivity type being formed below the electrodes of the image section at the interface between the buried channel and the dielectric layer. Such a device is known, for example, from US-A 5,115,458.

Charge-coupled devices or CCDs are generally known nowadays and have various fields of application. The main application is in cameras, both for professional purposes and for consumer purposes, in which the charge-coupled device is used as an image transducer by which a projected radiation image is convened into electrical signals. Although the invention should not be regarded as limited to image transducers, it is indeed explained below with reference to image transducers because of the particular advantages obtained in this CCD application through the invention. It will be perfectly obvious, however, that the invention also offers major advantages in other applications.

The three-layer construction with a substrate and a buried CCD channel of the one conductivity type, for example the n-type, separated from one another by an interposed region of the p-type in image transducers has the advantage that the excess charge caused by overexposure can be drained off through the substrate (vertical antiblooming) and that the exposure time, if so desired, may be adjusted in that charge generated during a certain portion of the maximum exposure time is drained off through the substrate (charge reset). An alternative CCD type with a three-layer construction is described *inter alia* in the article "1 GHz CCD transient detector" by Sankaranarayanan *et al*., presented at the IEDM '91, digest pp. 179/182. This relates to a high-frequency shift register with parallel channels in which excess charge packages are drained off through the substrate during demultiplexing.

It is generally known that in charge-coupled devices electrical signals are formed by packages of electric charge carriers which are stored in a depletion region induced at the surface. These packages comprise not only a signal component but also a component not equal to zero which is caused by leakage currents or dark currents. The generation of these leakage currents takes place for the major part in the depletion region, and in particular at the surface where the concentration of defects and of the accompanying states in the forbidden band in the energy diagram is comparatively high at the interface between the semiconductor and the gate dielectric. It is desirable to keep the dark currents as low as possible in general for reasons which are apparent *per se* such as, for example, the dynamic range of the signals or the maximum time during which a signal can be stored without regeneration.

The distribution of surface states is usually not uniform over the surface of the device, which means that the leakage currents may vary strongly depending on location. When the device is used as a shift register, in which the charge packages are stored in the various charge storage locations for approximately equal periods, these non-uniformities of the leakage current are more or less averaged out, whereby the various charge packages have each integrated an approximately equal leakage current at the output of the register, which can be compensated for through shifting of the DC level of the read-out signals. In a CCD image transducer, for example of the FT type, the pattern of charge packages is not moved during a comparatively long integration period in which the image is detected and converted into discrete charge packages. After the integration period, the charge pattern formed is transported to a memory section in a comparatively very short time. Since each charge package is stored in a given charge storage location acting as an image transducer element for a comparatively long time and during a much shorter time in other charge storage locations during transport, the said averaging-out of the leakage current over a large number of charge storage locations does not take place. This means that the non-uniformity of the leakage current becomes visible on a display screen (fixed pattern noise or FPN) when the converted image is displayed on this screen. In the case of a local defect, the dark current may lead to a complete filling of the relevant charge storage location with charge also without absorption of electromagnetic radiation, which results in a very unpleasant white spot on the display screen.

The cited US-A 5,115,458 discloses an n-channel CCD image transducer in which the clock electrodes are set to such a low voltage during the integration time that the surface below the clock electrodes is inverted, a layer of holes being stored at the interface. As is described in the US Patent, the dark current is substantially entirely suppressed, at least in as far as it results from surface states, because the surface is now no longer depleted.

In an embodiment of the known device having an n-type channel in a p-type zone provided in an n-type substrate, an excess charge caused by overexposure can be drained off through the substrate in the manner described above. Problems arise, however, in the case of the charge reset also described above owing to the inversion of the surface. The obvious method of removing all charge from the imaging section is to apply a negative voltage pulse to the clock electrodes of the imaging section whereby the electrons are "pushed" into the substrate, which itself was set for a positive bias voltage. This method cannot be used, however, in combination with the dark current reduction described because the surface potential is pinned to the voltage value of the p-type zone bounding the n-type channel by the inversion layer. A reduction of the gate voltage further than the threshold voltage will not or hardly cause the surface potential to drop further, so that it is impossible to remove the electrons.

In EP-A 0 399 551, a CCD imager of the interline type is disclosed provided with photodiodes besides the CCD registers for radiation detection. In this known device, charge can be removed selectively from the photodiodes.

The invention has for its object *inter alia* to provide a charge-coupled imaging device with a buried channel in which the dark current or leakage current is kept at a very low level through inversion of the surface, and which offers the possibility of charge reset through the substrate. The invention also has for its object to provide a charge-coupled imaging device of the frame transfer type (FT type), with a low dark current and/or a low FPN and with an exposure time which can be adjusted by means of charge reset.

According to the invention, a charge-coupled device of the kind mentioned in the opening paragraph is characterized in that the device is provided with charge reset means by which charge can be drained off from charge storage locations through the substrate by the application of a reset pulse, which means comprise a voltage source connected to the substrate and/or the interposed zone, charge being drained off through the substrate from only charge storage locations of the image section and means being present which prevent that simultaneously charge is drained off through the substrate from charge storage locations in the memory section. Voltages are applied to the various regions during operation such that the CCD channels are separated from the substrate by a potential baffler formed by the interposed p-type region. This baffler can be so reduced by the voltage pulse between the substrate and the interposed zone that electrons flow from the CCD channels to the substrate. However, since the substrate and/or the interposed zone, in an FT transducer, is/are common to the imaging section, the memory section and the horizontal read-out register, the application of a pulse without further measures could erase not only the imaging section but also the memory section, which may at that moment be filled with useful information, and/or the read-out register. This disadvantage is counteracted in a device according to the invention in that differences are provided between the various portions of the transducer such that the applied pulse is effective locally only in the transducer, for example in the imaging section only, and is not carried over to other sections, for example the memory section of an FT transducer. This renders it possible, in an FT transducer, to reset the imaging section, for example for reducing the exposure time, while a frame of image information is stored in the memory section for further processing.

In an embodiment, the interposed zone is connected to a constant potential and the voltage pulse is supplied to the substrate. In alternative embodiments, the substrate may be at a fixed potential while the reset pulse is supplied to the interposed zone.

To ensure that the reset pulse is effective in the imaging section and not in the memory section, a further embodiment of such an FT transducer is characterized in that, the clock voltages applied to the electrodes of the imaging section during the integration period are lower in the case of an n-channel device or higher in the case of a p-channel device than the corresponding clock voltages applied to the electrodes of the memory section. The voltage difference between the electrodes of the imaging section and of the memory section in this embodiment achieves that the potential wells in the memory section are deeper than those in the imaging section, whereby, for example in the case of an increasing substrate voltage, charge from the imaging section only is removed, and not the charge in the memory section. Owing to the higher voltage (in the case of an n-channel CCD) it is possible for the surface in the memory section not to be inverted, so that the dark current in the memory section may have a higher value than in the imaging section. This disadvantage is counteracted at least partly in that the charge packages in the memory section are not stored in a given storage location for a disproportionately long period, but are regularly transported from one storage location to a next one, whereby any local peaks in the dark current are evened out over the various charge packages. Another embodiment of an FT imaging device according to the invention, in which the surface can be inverted for decreasing the dark current also in the memory section, is characterized in that the clock voltages applied to the electrodes of the imaging section during the integration period have the same amplitudes as the clock voltages applied to the memory section except in those periods in which a reset pulse is applied, in which case a voltage is applied to the electrodes of the memory section below which a charge package is stored and at which no inversion occurs anymore at the surface. In this embodiment, accordingly, it is indeed necessary to change the level of the clock voltages in the memory section during a reset pulse in order to prevent charge being drained away from the memory section during resetting.

A further embodiment of an FT imaging device according to the invention is characterized in that the doping concentration per unit area of the interposed zone of the second conductivity type below the buried-channel registers in the memory section is higher than below the buried-channel registers in the imaging section. The selectivity in the charge removal is obtained here by inherent differences, in this case a difference in doping level, between the imaging section and the memory section or read-out register. Such a measure may be advantageously applied in combination with the differences in clock voltage levels referred to above between the imaging section and the memory section.

A preferred embodiment of a charge-coupled imaging device according to the invention, which has among its advantages that crosstalk of the substrate pulse to the output signals is prevented as much as possible, is characterized in that the reset pulse is supplied to the substrate in a period lying between reading-out of a final charge package of a first line of charge packages by the read-out register and reading-out of the first charge package of a second line of charge packages following said first line.

The invention will be explained in more detail with reference to a few embodiments and the accompanying diagrammatic drawing in which:
Fig. 1 is a cross-section of a charge-coupled imaging device according to the invention;
Fig. 2 is a cross-section of the same device in a plane perpendicular to the transport direction;
Fig. 3 shows a potential profile in a direction perpendicular to the surface during operation of this device;
Fig. 4a-e is a diagram of the clock voltages applied to this device;
Fig. 4f-g is a diagram of clock voltages in a second embodiment of a device according to the invention; and
Fig. 5 is a cross-section of a third embodiment of a device according to the invention.

It is noted that the drawing is diagrammatic and not true to scale.

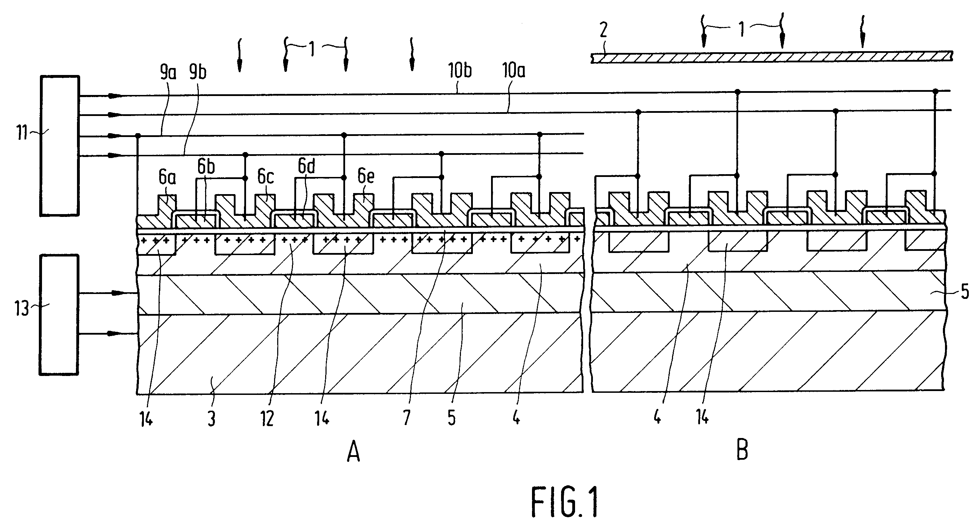

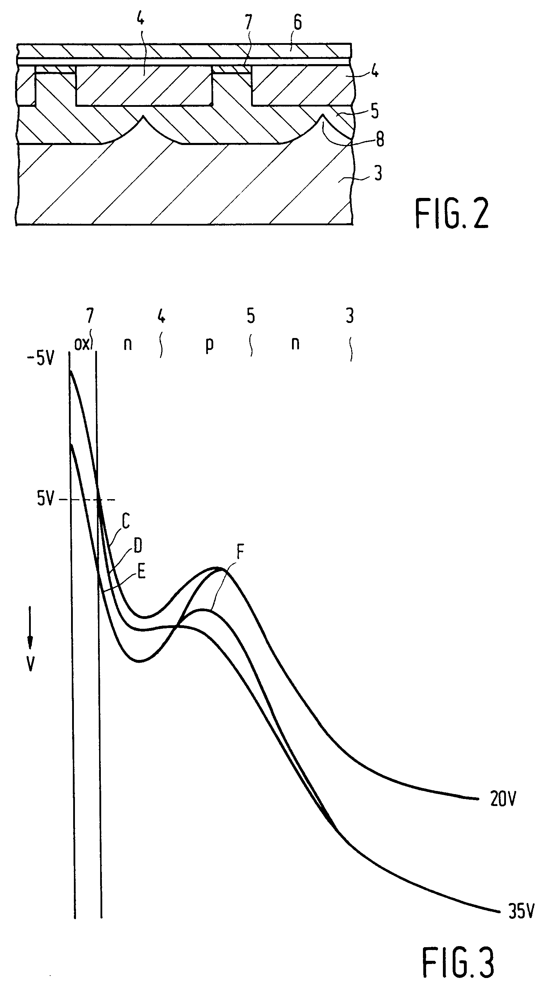

Fig. 1 is a cross-section taken parallel to the transport direction of a charge-coupled device according to the invention which together with a number of adjacent similar devices can be used as an imaging device of the FT (frame transfer) type. The device comprises an imaging section A onto which a radiation image represented by photons 1 can be projected and which converts the radiation image into a pattern of discrete charge packages. The value of each of these electric charge packages is a measure for the intensity of the locally captured radiation. The device further comprises a memory section B and a read-out register not shown in the drawing. The memory section is masked from incident radiation by a diagrammatically depicted light screen 2 and serves, as is generally known, for the storage of the charge patterns generated in the imaging section A. The device is of the buried-channel type and comprises a semiconductor substrate 3, for example made of silicon, of a first conductivity type, for example the n-type. The silicon substrate 3 is provided at its surface with a zone or region 4 of the same conductivity type as the substrate, so of the n-type, which is separated from the remaining portion of the n-type substrate at its lower side by an interposed zone 5 of the opposite conductivity type, so of the p-type. As is known, excess charge can be drained away from the transport channel 4 through the substrate in such a vertical npn configuration. The removal of the charge generated during a certain portion of the maximum integration time (charge reset) renders it possible, for example, to control the effective exposure time. In view of this charge removal, the layer 5 has such a composition that a depletion region is formed during operation which extends over the entire distance between the substrate 3 and the transport layer 4. To obtain a suitable potential barrier between the substrate and the region 4, the interposed region 5 is so provided that a constriction 8 (Fig. 2) is formed below the channel 4 in the region 5, so that the potential barrier is locally lower than in adjoining, thicker portions of the p-type interposed region 5.

The surface of the device is provided with an electrode system in usual manner, comprising the overlapping electrodes 6a, 6b, 6c, *etc*. provided in a 2-layer wiring and separated from the silicon surface by the thin gate dielectric layer 7. The electrodes 6 of the imaging section A and of the memory section B are connected to a voltage source 11 through connections or clock lines 9 and 10, respectively. The voltages applied to the electrodes 6 of the imaging section during the integration periods (during which an image is converted into a pattern of charge packages) are such that the surface of the channel coinciding with the interface between the dielectric layer 7 and the silicon of the channel 4 enters a state of inversion, *i.e*. a state in which a layer of holes is present at the interface. The inversion layer is diagrammatically depicted in Fig. 1 with the + signs 12. As was noted in the introduction, electrons generated by surface states recombine with holes in the inversion layer 12 so that a strong reduction of the dark current (leakage current), which is mainly formed by surface generation, is achieved.

The usual charge-resetting method, *i.e*. driving electrons from the imaging section into the substrate 3 by means of a negative voltage pulse at the gates of the imaging section, is not possible owing to the inversion at the surface by which the surface voltage is pinned to a certain value. The device according to the invention is therefore provided with charge reset means 13 comprising a voltage source connected to the substrate 3. By applying a positive voltage pulse to the substrate, it is possible to reduce the potential barrier in the p-type interposed region 5 to such an extent that electrons flow from a portion of the n-type transport layer 4, more precisely from the imaging section A, to the substrate. Since the substrate is common to the imaging section, the memory section and the output register (not shown), means are additionally provided by which it is prevented that charge is simultaneously drained off from other portions of the device, for example from the memory section B and/or the output register, upon the application of a substrate pulse. In the embodiment described here, these means comprise the clock voltage source 11 by means of which lower voltages are applied to the electrodes 6 of the imaging section A than to the electrodes 6 of the memory section B and to the clock electrodes of the read-out register. The voltages at the gates of the imaging section are chosen to be so low in this case that inversion occurs below the gates. The voltages at the gates of the memory section, at least those gates below which signals are stored, are chosen to be so high that no inversion occurs below these gates. Potential wells are induced below these gates thereby which are deeper than those below corresponding charge storage gates in the imaging section and which remain intact also in the case of a substrate pulse, as will become apparent from the description of the operation of the device.

The above obviously also holds for p-channel charge-coupled devices in which the polarities of the voltages are to be inverted compared with the n-channel device described here.

In a realised embodiment, a substrate 3 was used with a substrate doping of approximately 4 x 10¹⁴ atoms.cm⁻³. The p-type zones 5 were formed by implantation of boron with a dose of approximately 1.1 x 10¹² at.cm⁻². The maximum depth of the zones 5 was approximately 2.2 µm. To prevent n-type inversion channels being formed in the p-type zones 5 at the surface and to achieve that there will be a sufficient number of holes for forming an inversion layer in the CCD channels, the p-doping at the surface between the zones 4 is somewhat increased by means of an extra implantation (Fig. 2). The CCD channels 4 are formed by an n-implantation with a dose of 0.9 x 10¹² at.cm⁻². The depth of the zones 4 was approximately 1.0 µm. To obtain a potential profile of wells and barriers also in the situation in which the surface is in the inverted state, whereby the surface potential in fact is pinned to a certain value and accordingly practically does not change any more when the voltage is further decreased, an extra n-type doping is provided in the zones 14 within the n-zones 4 through implantation with a dose of 8.0 x 10¹² at.cm⁻². The zones 14 are provided at every other gate electrode, so that the device can be operated as a 2-phase CCD, each gate having a subjacent zone 14 being connected to a preceding gate without a zone 14. During operation, the extra n-doping in the zones 14 causes an extra positive potential whereby in the case of, for example, equal voltages at the gates 6d and 6e, a potential well is formed below the gate 6e where charge can be stored. It will be obvious that alternative methods known *per se* and combinations of such methods for creating a non-uniform potential below the gate electrodes may be used, such as the use of a gate dielectric of a non-uniform thickness. It is also possible to provide a p-type doping at the areas of the potential barriers, whereby the net concentration of the n-type impurity is locally reduced, instead of an extra n-doping at the areas of potential wells. The gate dielectric 7 is formed by a layer of silicon oxide of approximately 100 nm thickness. The gate electrodes 6 are provided in a 2-layer wiring of polycrystalline silicon, referred to as poly 1 and poly 2 hereinafter. The gates in poly 1 (lower poly layer) are situated, seen at the surface, between the more highly doped n-zones 14 which can be provided in a self-aligning manner known *per se* relative to these gates after the definition of the poly 1 gates. After the implantation of the zones 14, the gates in the poly 2 layer, which are situated over the zones 14 and accordingly act as storage gates, are provided. The poly layers are mutually separated by an interposed interpoly dielectric, for example in the form of an oxide layer. A usual glass layer (not shown in the drawing) is provided over the entire construction, with contact openings through which the gates are connected to the clock lines 9 and 10.

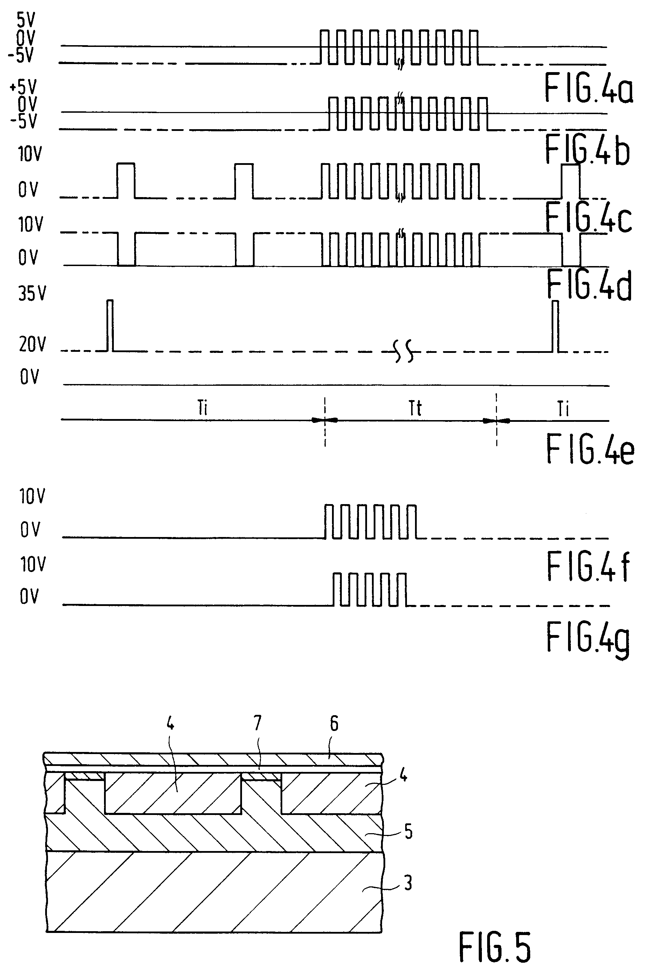

The construction of the device in the present embodiment is practically the same for the imaging section and the memory section in the sense that the cross-section according to Fig. 2 could be made both in the imaging section and in the memory section. In a first operating mode, the voltages are applied to the device as shown in Fig. 4 as a function of time. A voltage of, for example, 20 V is applied to the substrate 3, and increased to 35 V during resetting (Fig. 4e). A voltage of 5 V is applied to the p-region 5 between the substrate and the CCD channels, which corresponds to the surface potential in the more highly doped p-zones between the CCD channels. The clock voltages drawn in Figs. 4a and 4b are applied to the gates 6 of the imaging section through the clock lines 9a and 9b, respectively. The clock voltages drawn in Figs. 4c and 4d are applied to the gates 6 of the memory section through the clock lines 10a and 10b, respectively. Fig. 4 in addition shows a time interval Tₜ and intervals Tᵢ. During the transport time Tₜ, a charge pattern formed in the imaging section is transported from the imaging section to the memory section, while in the integration time Tᵢ a new radiation image is captured in the imaging section while a previous image, stored in the memory section, is read out.

Given the doping levels and oxide thicknesses of the gate dielectric 7 mentioned here, the threshold voltage at which p-inversion channels are formed at the surface in the CCD channels at the areas of the more highly doped n-zones is approximately 9 V. The threshold voltage is lower in the regions between the zones 14 owing to the lower n-doping. A voltage of -5 V is applied to the gates 6 of the imaging section during the integration period Tᵢ. The 5 V at the p-zone 5 then inverts the entire surface in the CCD channels of the imaging section and pins it to a potential of approximately 5 V. Owing to the doping profile in the CCD channels, a potential profile of potential wells at the more highly doped zones 14 alternating with potential barriers in which the generated electrons are integrated into charge packages is created in these channels at a distance from the surface. Simultaneously, information stored in the memory section can be read out, for which purpose clock voltages between 0 and 10 V are applied to the gates 6 of the memory section for 2-phase transport to the output register. No inversion occurs at these voltages, which will mean in general that the dark current is slightly greater in the memory section. As was noted above, this dark current is less disadvantageous here than in the imaging section because peaks in the dark current are averaged out over an entire column by the charge transport. A voltage of 20 V is applied to the substrate, whereby the pn junction between the n-substrate 3 and the p-zone 5 is reverse biased.

To clarify the operation of the device, a number of potential profiles in a direction transverse to the surface are drawn in Fig. 3 for various gate voltages and substrate voltages at the area of a more highly doped zone 14. For a correct understanding it is noted that the (positive) potential is plotted in downward direction. The Figure also shows the gate oxide layer 7, the CCD channel 4, the p-region 5 and the substrate 3. Curve C shows the situation at a gate voltage of 5 V and a substrate voltage of 20 V. A potential minimum is formed in the channel 4 in which charge can be stored and which is separated from the substrate by a barrier in the p-region 5 as long as the charge quantity does not exceed a certain maximum. This property is employed in imaging devices, as is generally known, for preventing blooming in the case of overexposure. As is shown in Fig. 3, the potential at the barrier in the p-region 5 may be higher than 5 V owing to the fields induced in the fully depleted portion of the p-region 5 situated between the CCD channel and the substrate. When the charge generated during a portion of the integration period is to be removed (charge reset), for example for adjusting the effective exposure time, a pulse of 35 V is applied to the substrate, as is shown in Fig. 4. Curve C then merges into curve D, in which the barrier in the p-region 5 has disappeared entirely or at least substantially entirely, so that the electrons which were stored in the well of curve C are drained off through the substrate 3. When the substrate voltage is restored to 20 V again, curve C is obtained again at the gate voltage of 5 V with a potential well in which charge can again be integrated. A potential profile in accordance with curve E is obtained at a higher gate voltage. The surface potential is higher than 5 V, so that no inversion takes place at the surface. The potential well in the CCD channel 4 is deeper here than in curve C. When the substrate pulse of 35 V is applied at this gate voltage, whereby curve E merges into curve F, a sufficiently high barrier can remain in the p-region 5 for preventing charge transport to the substrate. This means that charge will be drained away from the imaging section A only in the case of a 35 V substrate pulse, and that the information captured during the preceding integration period remains in the memory section B.

During the integration time Tᵢ, the charge in the memory section is transported to the output register in a 2-phase transport. The clock voltages used for this are shown in Figs. 4c and 4d. These voltages alternate between the levels 0 V and 10 V. No inversion takes place at the surface during this, which is favourable for charge transport. Preferably, this charge transport takes place, as does the charge removal from the imaging section, by means of the substrate pulse in a period between reading-out of two consecutive lines of charge packages *via* the output register. Crosstalk of the substrate pulse or reset pulse on the output of the device can be limited in an advantageous manner thereby.

When the integration period Tᵢ has elapsed and the memory section B is empty, the pattern of charge packages generated in the imaging section A is transferred to the memory section. Comparatively high-frequency, 2-phase clock voltages are supplied to the gates 6 of both the imaging section A and the memory section B through the clock lines 9 and 10 for the purpose of this transfer during the transport time Tₜ. In the embodiment of Figs. 4a and 4b, the levels of the various clock voltages are not changed, *i.e*. the clock voltages in the imaging section alternate between - 5 V and +5 V and in the memory section between 0 V and 10 V, which is convenient for the control circuits. If it is desirable to carry out the transport without inversion in the imaging section, for example to achieve a low charge loss during transport, the clock voltages of the imaging section may be brought to the same levels as the clock voltages in the memory section, so to 0 V and 10 V. It is also possible to maintain the clock voltages in the imaging section at -5 V and +5 V and to reduce the voltage at the p-type interposed region 5 temporarily to, for example, 0 V during frame transport, as a result of which the -5 V voltage is insufficiently low for inversion.

In the embodiment described here, four different voltage levels are used for the gates 6: -5 V, 0 V, +5 V and 10 V. Figs. 4f and 4g show an embodiment in which the gate voltages in the imaging section alternate between 0 V and 10 V, so between the same values as the gate voltages in the memory section, so that no more than two voltage levels can suffice. It is assumed that the composition of the device as regards, for example, doping concentrations and thicknesses of the various regions and layers has not changed relative to the previous embodiment. A voltage of 10 V is applied to the p-type interposed region 5. A voltage of 0 V is applied to the gates 6 of the imaging section A during the integration period Tᵢ, so that a potential profile arises in the CCD channel 4 with wells and barriers in which generated charge can be stored in the form of electron packages. Since there is a potential difference of 10 V between the p-region 5 and the gates 6 in the imaging section, the entire or at least substantially the entire surface in the imaging section will be in the inverted state at a threshold voltage of 9 V in the more highly doped n-zones 14. The information stored in the memory section is transported to the output register by the 2-phase clock voltages of Figs. 4c and 4d. The electrons are stored then below the gates to which the 10 V voltage is applied. The subjacent portion of the surface is not inverted at this voltage. When a voltage pulse of 35 V is applied to the substrate for the purpose of charge reset, the charge stored in the imaging section is drained off through the substrate in the manner described with reference to Fig. 3. Since the charge is stored in potential wells induced below the gates to which 10 V is applied (Fig. 4d) in the memory section, which wells are substantially deeper than those in the imaging section owing to the fact that the surface is not inverted in those locations in the memory section, the charge is not drained off in the memory section. Clock voltages of 0 and 10 V are applied to the gates 6 of the imaging section A and the memory section B during the transport period Tₜ. The surface can become inverted at the 0 V voltage level, so that a reduction of the leakage current can be obtained also during transport. After transport, when the imaging section is empty and all charge packages have been stored in the memory section, the gates of the imaging section are set for 0 V again so that an image can be captured again in the imaging section, with or without a preceding charge reset.

A third method of selectively removing charge from the imaging section by means of the substrate voltage is depicted diagrammatically in Fig. 5. In this Figure, a portion of the memory section is shown in a cross-section transverse to the charge transport direction. The principle of the imaging section is identical to that of the imaging section in the previous embodiments, *i.e*. its cross-section is as shown in Fig. 2. The p-type interposed region 5, at least the portion thereof situated below the CCD channels 4, has a substantially uniform thickness without the constrictions 8 in the imaging section. The result of this uniform thickness of the layer 5 is that the potential barrier between the zones 4 and the substrate 3 in the memory section is higher than in the imaging section owing to the difference in the doping concentration per cm² during operation, when the layer 5 is fully depleted below the zones 4. The higher potential barrier below the gates of the memory section renders it possible to maintain a sufficient barrier in the case of a substrate pulse for preventing the removal of charge to the substrate, while the lower barrier in the imaging section disappears entirely or at least substantially entirely, so that charge present locally flows to the substrate. In this manner the information in the memory section can be protected also when voltages are applied to the gates in the memory section such that inversion takes place at the surface also in this section. This method may also be combined, however, with the methods described above in which higher voltages were applied to the gates of the memory section below which charge was stored than to corresponding gates of the imaging section. This leads *inter alia* to the advantage that the risk of charge losses in the memory section during a positive substrate pulse is further reduced.

In the embodiment described here, the charge reset pulse is applied to the substrate at a fixed potential at the p-type interposed zone 5. In some versions, for example when peripheral electronics are integrated with the imaging device on the same crystal, it may be advantageous to apply the reset pulse to the interposed zone 5 instead of to the substrate in order to reduce the barrier between substrate and CCD channel. To obtain the desired selectivity in the charge removal, it is possible to make use of differences in voltages applied to the charge storage gates of the imaging section on the one hand and of the memory section on the other hand. It is also possible to apply different voltages to the portions of the p-type interposed zone 5 in the imaging section and the memory section, owing to the comparatively high resistance in this zone. The more highly doped channel-interrupting p-type surface zone in the zone 5 may be advantageously provided with an interruption at the boundary between the imaging section and the memory section in that case.

It will be obvious that the invention is not limited to the embodiments described here, but that many more variations are possible to those skilled in the art within the scope of the invention. Thus the desired selectivity in charge removal may also be obtained in that the n-concentration in the memory section is chosen to be different from that in the imaging section. The conductivity types of the various zones and regions in the semiconductor body may also be reversed, in which case obviously the polarities of the various voltages should also be reversed. It is also possible to carry out charge reset selectively in, for example, the memory section only or the output register without removing the charge in the imaging section in that different voltages are applied to the gates of the imaging section and the memory section.

## Claims

1. A buried-channel coupled imaging device of the frame-transfer type comprising a semiconductor substrate (3) of a first conductivity type which is provided at a surface with a number of zones (4) of the first conductivity type, which zones are separated from the substrate of the first conductivity type by an interposed zone (5) of the second conductivity type opposite to the first, said zones forming a number of registers with buried channels situated next to one another, a first part of said registers forming an image section (A), an adjoining second part of said registers forming a memory section (B), located and connected between the image section and a parallel-in/serial-out read-out register, while the surface at the image section and the memory section is provided with a system of electrodes (6) for applying clock voltages separated from the buried channels by an interposed dielectric layer (7) and connected to a voltage source (11) by means of which said clock-voltages are applied, an inversion layer (12) of the second conductivity type being formed below the electrodes of the image section at the interface between the buried channel and the dielectric layer, characterized in that the device is provided with charge reset means (13) by which charge can be drained off from charge storage locations through the substrate by the application of a reset pulse, which means comprise a voltage source connected to the substrate and/or the interposed zone, charge being drained off through the substrate from only charge storage locations of the image section and means being present which prevent that simultaneously charge is drained off through the substrate from charge storage locations in the memory section.

2. A charge-coupled device in Claim 1, characterized in that the clock voltages applied to the electrodes of the imaging section during the integration period are lower in the case of an n-channel device or higher in the case of a p-channel device than the corresponding clock voltages applied to the electrodes of the memory section.

3. A charge-coupled device as claimed in Claim 1, characterized in that the clock voltages applied to the electrodes of the imaging section during the integration period have the same amplitudes as the clock voltages applied to the memory section except in those periods in which the reset pulse is applied between the substrate and the interposed zone, in which case a voltage is applied to the electrodes of the memory section below which a charge package may be stored and at which no inversion occurs anymore at the surface.

4. A charge-coupled device as claimed in Claim 1, characterized in that the doping concentration per unit area of the interposed zone of the second conductivity type below the buried-channel registers in the memory section is higher than below the buried-channel registers in the imaging section.

5. A charge coupled device as claimed in any one of the preceding Claims, characterized in that the reset pulse is supplied to the substrate in a period lying between reading-out of a final charge package of a first line of charge packages by the read-out register and reading-out of the first charge package of a second line of charge packages following said first line.

## Patentansprüche

1. Ladungsgekoppelte Bildsyntheseanordnung vom Bildrastertransfertyp mit einem Halbleitersubstrat (3) eines ersten Leitungstyps, das an einer Oberfläche mit einer Anzahl Zonen (4) vom ersten Leitungstyp versehen ist, welche Zonen vom Substrat des ersten Leitungstyps durch eine dazwischen liegende Zone (5) des dem ersten entgegengesetzten, zweiten Leitungstyps getrennt sind, wobei diese Zonen eine Anzahl Register mit nebeneinander liegenden vergrabenen Kanälen bilden, wobei ein erster Teil der genannten Register einen Bildabschnitt (A) bildet, ein angrenzender zweiter Teil der genannten Register einen Speicherabschnitt (B) bildet, der zwischen dem Bildabschnitt und einem PISO-Ausleseregister (PISO: parallel-in, serial-out) liegt und zwischen diese geschaltet ist, während die Oberfläche am Bildabschnitt und dem Speicherabschnitt mit einem System aus Elektroden (6) versehen ist, um Taktspannungen anzulegen, die durch eine dazwischen liegende dielektrische Schicht (7) von den vergrabenen Kanälen getrennt und mit einer Spannungsquelle (11) verbunden sind, mit der die genannten Taktspannungen angelegt werden, wobei eine Inversionsschicht (12) des zweiten Leitungstyps unter den Elektroden des Bildabschnitts an der Grenzfläche zwischen dem vergrabenen Kanal und der dielektrischen Schicht gebildet wird, dadurch gekennzeichnet, dass die Anordnung mit Ladungsrücksetzmitteln (13) versehen ist, mit denen Ladung aus Ladungsspeicherstellen durch Anlegen eines Rücksetzimpulses durch das Substrat abgeführt werden kann, welche Mittel eine mit dem Substrat und/oder der dazwischen liegenden Zone verbundene Spannungsquelle umfassen, wobei Ladung nur aus Ladungsspeicherstellen des Bildabschnitts durch das Substrat abgeführt wird und Mittel vorhanden sind, die verhindern, dass gleichzeitig Ladung aus Ladungsspeicherstellen im Speicherabschnitt durch das Substrat abgeführt wird.

2. Ladungsgekoppelte Anordnung nach Anspruch 1, dadurch gekennzeichnet, dass die während des Integrationszeitraums an die Elektroden des Bildsyntheseabschnitts angelegten Taktspannungen im Fall einer n-Kanal-Anordnung niedriger oder im Fall einer p-Kanal-Anordnung höher als die entsprechenden an die Elektroden des Speicherabschnitts angelegten Taktspannungen sind.

3. Ladungsgekoppelte Anordnung nach Anspruch 1, dadurch gekennzeichnet, dass die an die Elektroden des Bildsyntheseabschnitts während des Integrationszeitraums angelegten Taktspannungen die gleichen Amplituden haben wie die an den Speicherabschnitt angelegten Taktspannungen, außer in den Zeiträumen, in denen der Rücksetzimpuls zwischen dem Substrat und der dazwischen liegenden Zone angelegt wird, in welchem Fall an die Elektroden des Speicherabschnitts, unter denen ein Ladungspaket gespeichert werden kann, eine Spannung angelegt wird, bei der keine Inversion an der Oberfläche mehr auftritt.

4. Ladungsgekoppelte Anordnung nach Anspruch 1, dadurch gekennzeichnet, dass die Dotierungskonzentration pro Flächeneinheit der dazwischen liegenden Zone des zweiten Leitungstyps unter den Registern mit vergrabenem Kanal in dem Speicherabschnitt höher ist als unter den Registern mit vergrabenem Kanal im Bildsyntheseabschnitt.

5. Ladungsgekoppelte Anordnung nach einem der vorhergehenden Ansprüche, dadurch gekennzeichnet, dass der Rücksetzimpuls dem Substrat in einem Zeitraum zugeführt wird, der zwischen Auslesen eines letzten Ladungspakets einer ersten Reihe von Ladungspaketen durch das Ausleseregister und Auslesen des ersten Ladungspakets einer zweiten Reihe von Ladungspaketen, die der ersten Reihe folgt, liegt.

## Revendications

1. Dispositif de formation d'image à couplage de charge du type à canal enterré et de transmission de trame comprenant un substrat semi-conducteur (3) présentant un premier type de conductivité qui est muni, à une surface, d'un nombre déterminé de zones (4) présentant le premier type de conductivité, lesquelles zones sont séparées du substrat présentant le premier type de conductivité par une zone interposée (5) présentant le deuxième type de conductivité qui est opposé au premier type de conductivité, lesdites zones formant un nombre déterminé de registres munis de canaux enterrés situés les uns à côté des autres, une première partie desdits registres formant une section d'image (A), une deuxième partie voisine desdits registres formant une section de mémoire (B), située et connectée entre la section d'image et un registre de lecture entrée parallèle/sortie série prévu à la section d'image et à la section de mémoire, alors que la surface est munie d'un système d'électrodes (6) pour appliquer des tensions d'horloge, lesquelles électrodes sont séparées des canaux enterrés par une couche diélectrique interposée (7) et connectées à une source de tension (11) à l'aide de laquelle lesdites tensions d'horloge sont appliquées, une couche d'inversion (12) présentant le deuxième type de conductivité étant formée au-dessous des électrodes de la section d'image à l'interface comprise entre le canal enterré et la couche diélectrique, caractérisé en ce que le dispositif est muni de moyens de rétablissement de charge (13) à l'aide desquels la charge peut être évacuée à partir des positions de stockage de charge par l'intermédiaire du substrat par l'application d'une impulsion de rétablissement, lesquels moyens comprennent une source de tension connectée au substrat et/ou à la zone interposée, la charge étant évacuée par l'intermédiaire du substrat de seulement les positions de stockage de charge de la section d'image et des moyens étant présents qui empêchent que simultanément la charge ne soit évacuée par l'intermédiaire du substrat à partir des positions de stockage de charge dans la section de mémoire.

2. Dispositif à couplage de charge selon la revendication 1, caractérisé en ce que les tensions d'horloge appliquées aux électrodes de la section d'image pendant la période d'intégration sont plus basses dans le cas d'un dispositif à canal n ou plus élevées dans le cas d'un dispositif à canal p que les tensions d'horloge correspondantes appliquées aux électrodes de la section de mémoire.

3. Dispositif à couplage de charge selon la revendication 1, caractérisé en ce que les tensions d'horloge appliquées aux électrodes de la section d'image pendant la période d'intégration présentent les mêmes amplitudes que les tensions d'horloge appliquées à la section de mémoire, à l'exception des périodes pendant lesquelles l'impulsion de rétablissement est appliquée entre le substrat et la zone interposée, cas dans lequel une tension est appliquée aux électrodes de la section de mémoire au-dessous de laquelle est stocké un paquet de charge et à laquelle il ne se produit plus une inversion à la surface.

4. Dispositif à couplage de charge selon la revendication 1, caractérisé en ce que la concentration de dopage par unité de surface de la zone interposée présentant le deuxième type de conductivité au-dessous des registres de canal enterré dans la section de mémoire est plus élevée que celle se produisant au-dessous des registres de canal enterré présents dans la section d'image.

5. Dispositif à couplage de charge selon l'une des revendications précédentes, caractérisé en ce que l'impulsion de rétablissement est amenée au substrat dans une période comprise entre la lecture d'un paquet de charge final d'une première ligne de paquets de charge par le registre de lecture et la lecture du premier paquet de charge d'une deuxième ligne de paquets de charge succédant à ladite première ligne.
